# EUROPEAN PATENT SPECIFICATION

(11) **EP 3 272 782 B1**
(45) Date of publication and mention of the grant of the patent: **22.03.2023**
(21) Application number: 16764566.2
(22) Date of filing: 04.02.2016
(51) Int. Cl.: C08G 59/26, B32B 15/08, H05K 1/03, C08G 59/40, B32B 5/02, B32B 7/12, B32B 15/20, B32B 27/18, B32B 27/20, B32B 27/28, B32B 15/14, B32B 27/32, B32B 27/36, C08J 5/24

(54) **RESIN COMPOSITION, PREPREG, METAL FOIL-CLAD LAMINATE, RESIN SHEET, AND PRINTED WIRING BOARD**
HARZZUSAMMENSETZUNG, PREPREG, METALLFOLIENKASCHIERTES LAMINAT, HARZFOLIE UND LEITERPLATTE
COMPOSITION DE RÉSINE, PRÉIMPRÉGNÉ, STRATIFIÉ GAINÉ D'UNE FEUILLE MÉTALLIQUE, FEUILLE DE RÉSINE ET CARTE DE CIRCUIT MPRIMÉ

(30) Priority: 18.03.2015 JP 2015054268
(43) Date of publication of application: 24.01.2018
(73) Proprietor: Mitsubishi Gas Chemical Company, Inc., Tokyo 100-8324 (JP)
(72) Inventor: KOBAYASHI, Takashi, Tokyo 125-8601 (JP); TAKANO, Kentaro, Tokyo 125-8601 (JP); HIRAMATSU, Sotaro, Tokyo 125-8601 (JP)
(74) Representative: Hoffmann Eitle
(86) International application number: PCT/JP2016/053365
(87) International publication number: WO 2016/147735

(56) References cited:
- EP-A1- 2 716 676
- WO-A1-2011/114687
- WO-A1-2013/183735
- WO-A1-2013/183736
- WO-A1-2016/014536
- FR-A- 1 519 027
- GB-A- 1 158 606
- JP-A- 2014 024 970
- MONTSERRAT S ED - BALLAUFF MATTHIAS ET AL: "Effect of crosslinking density on @DC"p(T"g) in an epoxy network", POLYMER, ELSEVIER SCIENCE PUBLISHERS B.V, GB, vol. 36, no. 2, 1 January 1995 (1995-01-01), pages 435-436, XP004026063, ISSN: 0032-3861, DOI: 10.1016/0032-3861(95)91337-7

## Description

### Technical Field

The present invention relates to a resin composition, a prepreg, a metal foil-clad laminate, a resin sheet, and a printed wiring board.

### Background Art

In recent years, higher integration and miniaturization of semiconductors widely used in electronic equipment, communication instruments, personal computers, and the like have accelerated increasingly. With this, various characteristics required of laminates for semiconductor packages used in printed wiring boards have become increasingly strict. Examples of the required characteristics include characteristics such as low water absorbency, moisture absorption heat resistance, flame retardancy, a low dielectric constant, a low dielectric loss tangent, a low thermal expansion coefficient, heat resistance, chemical resistance, and high plating peel strength. But, these required characteristics have not always been satisfied so far.

Conventionally, as resins for printed wiring boards having excellent heat resistance and electrical characteristics, cyanate compounds are known, and resin compositions using the cyanate resins in combination with epoxy resins and the like have been widely used for materials for highly functional printed wiring boards such as for semiconductor plastic packages, and the like in recent years. In addition, due to smaller size and higher density of multilayer printed wiring boards, thinning laminates used for multilayer printed wiring boards is actively studied. WO 2013/183735 A1 relates to an epoxy resin, an epoxy resin composition and a cured product thereof suitable for use in electric and electronic materials requiring heat resistance.

### Citation List

### Patent Literature

Patent Literature 1: International Publication No. WO 2013/065694
Patent Literature 2: International Publication No. WO 2014/203866

### Summary of Invention

### Technical Problem

However, when a laminate is thinned, the problem of an increase in the warpage of a multilayer printed wiring board occurs. In order to suppress this warpage of a multilayer printed wiring board, the characteristics of a high glass transition temperature when a cured product is formed are required of a resin composition that is a material of an insulating layer. In addition, resin compositions comprising a cyanate and an epoxy resin that have excellent characteristics such as adhesiveness, low water absorbency, moisture absorption heat resistance, and insulation reliability are proposed (for example, see Patent Literatures 1 and 2), but characteristics improvement in the above glass transition temperature is still insufficient, and therefore further improvement in the above glass transition temperature is required.

The present invention has been made in view of the above problems of the conventional art, and an object of the present invention is to provide a resin composition that has a high glass transition temperature when formed into a cured product.

### Solution to Problem

The present inventors have diligently studied the above problems and, as a result, found that a cured product having a high glass transition temperature is obtained by using a resin composition containing a cyanate compound (A) and an epoxy resin (B) having a predetermined structure, arriving at the present invention. Specifically, the present invention is as defined in the appended claims.

### Advantageous Effects of Invention

According to the resin composition according to the present invention, a prepreg, a metal foil-clad laminate, a resin sheet, and a printed wiring board that are cured products having a high glass transition temperature can be realized.

### Description of Embodiments

A mode for carrying out the present invention (hereinafter simply referred to as "this embodiment") will be described in detail below.

### <Resin Composition>

A resin composition in this embodiment comprises a cyanate compound (A); and an epoxy resin (B) represented by general formula (1): 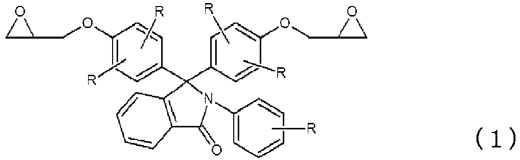
wherein a plurality of R each independently represent any of a hydrogen atom, an alkyl group having 1 to 6 carbon atoms, and an alkoxy group having 1 to 6 carbon atoms;
wherein the cyanate compound (A) is comprised in 1 to 90% by mass and the epoxy resin (B) is comprised in 1 to 90% by mass based on the total amount (100% by mass) of the resin solids in the resin composition; and wherein the cyanate compound (A) is a naphthol aralkyl-based cyanate compound.

The resin composition in this embodiment contains the cyanate compound and the above epoxy resin (B), and thus has a high glass transition temperature when formed into a cured product. The factor contributing to this is presumed as follows (however, the factor is not limited to this). Two epoxy groups of the epoxy resin (B) represented by general formula (1) have excellent reactivity with the cyanate compound (A) in this embodiment, and therefore the crosslinking reaction proceeds efficiently when a cured product is formed. Particularly under reaction conditions when a cured product as a prepreg, a metal foil-clad laminate, a resin sheet, or a printed wiring board in this embodiment is obtained from the resin composition in this embodiment, the above crosslinking reaction proceeds efficiently. Thus, it is presumed that the resin composition in this embodiment has a high glass transition temperature when formed into a cured product.

The cyanate compound (A) in this embodiment (hereinafter also referred to as a "cyanate compound", a "component (A)", or "(A)") is a naphthol aralkyl-based cyanate compound, which is a resin having in the molecule an aromatic moiety substituted by at least one cyanato group (cyanate group).

Examples of the cyanate compound (A) include a compound represented by general formula (2): 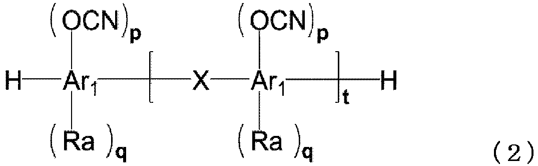 wherein Ar₁ represents a naphthylene group that may have a substituent. Ra represents any of a hydrogen atom, an alkyl group having 1 to 6 carbon atoms that may have a substituent, an aryl group having 6 to 12 carbon atoms that may have a substituent, an alkoxyl group having 1 to 4 carbon atoms that may have a substituent, an aralkyl group that may have a substituent in which an alkyl group having 1 to 6 carbon atoms and an aryl group having 6 to 12 carbon atoms are bonded to each other, and an alkylaryl group that may have a substituent in which an alkyl group having 1 to 6 carbon atoms and an aryl group having 6 to 12 carbon atoms are bonded to each other, and Ra is each independently as defined above when a plurality of Ra are present. p represents the number of cyanato groups bonded to Ar₁, and the number of the cyanato groups is an integer of 1 to 3, and the numbers of the cyanato groups are each independently as defined above when a plurality of the numbers of the cyanato groups are present. q represents the number of Ra bonded to Ar₁, and the number of the Ra is, for example, 6 - p when Ar₁ is a naphthylene group, and the numbers of the Ra are each independently as defined above when a plurality of the numbers of the Ra are present. t represents the average number of repetitions, and the average number of repetitions is an integer of 0 to 50, and the compound represented by general formula (2) may be a mixture of compounds having different t. X is a group represented by formula (3) below.

In general formula (2), the alkyl group represented by Ra may have any of a chain structure and a cyclic structure (for example, a cycloalkyl group). In addition, in general formula (2), hydrogen atoms in the alkyl group and the aryl group represented by Ra may each be independently replaced by a halogen atom such as fluorine or chlorine; an alkoxyl group such as a methoxy group or a phenoxy group; a cyano group; or the like.

The above alkyl group is not particularly limited. Examples thereof include a methyl group, an ethyl group, a propyl group, an isopropyl group, a n-butyl group, an isobutyl group, a tert-butyl group, a n-pentyl group, a 1-ethylpropyl group, a 2,2-dimethylpropyl group, a cyclopentyl group, a hexyl group, a cyclohexyl group, and a trifluoromethyl group.

Examples of the above aryl group are not particularly limited and include a phenyl group, a xylyl group, a mesityl group, a naphthyl group, a phenoxyphenyl group, an ethylphenyl group, o-, m-, and p-fluorophenyl groups, a dichlorophenyl group, a dicyanophenyl group, a trifluorophenyl group, a methoxyphenyl group, and o-, m-, and p-tolyl groups.

The above alkoxyl group is not particularly limited. Examples thereof include a methoxy group, an ethoxy group, a propoxy group, an isopropoxy group, a n-butoxy group, an isobutoxy group, a tert-butoxy group, and a phenoxy group.

X in general formula (2) is a group having a structure represented by general formula (3). 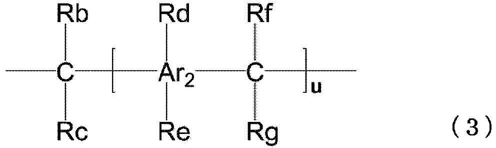 wherein Ar₂ represents any of a phenylene group, a naphthylene group, and a biphenylene group, and Ar₂ is each independently as defined above when a plurality of Ar₂ are present. Rb, Rc, Rf, and Rg each independently represent any of a hydrogen atom, an alkyl group having 1 to 6 carbon atoms, an aryl group having 6 to 12 carbon atoms, a trifluoromethyl group, and an aryl group substituted by at least one phenolic hydroxy group. In addition, Rb, Rc, Rf, and Rg when a plurality of Rb, Rc, Rf, and Rg are present are each independent. Rd and Re each independently represent any of a hydrogen atom, an alkyl group having 1 to 6 carbon atoms, an aryl group having 6 to 12 carbon atoms, an alkoxyl group having 1 to 4 carbon atoms, and a hydroxy group. In addition, Rd and Re when a plurality of Rd and Re are present are each independent. u represents an integer of 0 to 5, and the compound represented by general formula (2) may be a mixture of compounds having different u.

Ar₂ in general formula (3) is not particularly limited. Examples thereof include a 1,4-phenylene group, a 1,3-phenylene group, a 4,4'-biphenylene group, a 2,4'-biphenylene group, a 2,2'-biphenylene group, a 2,3'-biphenylene group, a 3,3'-biphenylene group, a 3,4'-biphenylene group, a 2,6-naphthylene group, a 1,5-naphthylene group, a 1,6-naphthylene group, a 1,8-naphthylene group, a 1,3-naphthylene group, and a 1,4-naphthylene group.

The alkyl groups and the aryl groups represented by Rb to Rf in general formula (3) are each independently similar to the one described in general formula (2).

Examples of the cyanate compound (A) (but not necessarily forming part of the present invention) are not particularly limited and include cyanatobenzene, 1-cyanato-2-, 1-cyanato-3-, or 1-cyanato-4-methylbenzene, 1-cyanato-2-, 1-cyanato-3-, or 1-cyanato-4-methoxybenzene, 1-cyanato-2,3-, 1-cyanato-2,4-, 1-cyanato-2,5-, 1-cyanato-2,6-, 1-cyanato-3,4-, or 1-cyanato-3,5-dimethylbenzene, cyanatoethylbenzene, cyanatobutylbenzene, cyanatooctylbenzene, cyanatononylbenzene, 2-(4-cyanatophenyl)-2-phenylpropane (a cyanate of 4-α-cumylphenol), 1-cyanato-4-cyclohexylbenzene, 1-cyanato-4-vinylbenzene, 1-cyanato-2- or 1-cyanato-3-chlorobenzene, 1-cyanato-2,6-dichlorobenzene, 1-cyanato-2-methyl-3-chlorobenzene, cyanatonitrobenzene, 1-cyanato-4-nitro-2-ethylbenzene, 1-cyanato-2-methoxy-4-allylbenzene (a cyanate of eugenol), methyl(4-cyanatophenyl)sulfide, 1-cyanato-3-trifluoromethylbenzene, 4-cyanatobiphenyl, 1-cyanato-2- or 1-cyanato-4-acetylbenzene, 4-cyanatobenzaldehyde, methyl 4-cyanatobenzoate ester, phenyl 4-cyanatobenzoate ester, 1-cyanato-4-acetaminobenzene, 4-cyanatobenzophenone, 1-cyanato-2,6-di-tert-butylbenzene, 1,2-dicyanatobenzene, 1,3-dicyanatobenzene, 1,4-dicyanatobenzene, 1,4-dicyanato-2-tert-butylbenzene, 1,4-dicyanato-2,4-dimethylbenzene, 1,4-dicyanato-2,3,4-trimethylbenzene, 1,3-dicyanato-2,4,6-trimethylbenzene, 1,3-dicyanato-5-methylbenzene, 1-cyanato- or 2-cyanatonaphthalene, 1-cyanato4-methoxynaphthalene, 2-cyanato-6-methylnaphthalene, 2-cyanato-7-methoxynaphthalene, 2,2'-dicyanato-1,1'-binaphthyl, 1,3-, 1,4-, 1,5-, 1,6-, 1,7-, 2,3-, 2,6-, or 2,7-dicyanatonaphthalene, 2,2'- or 4,4'-dicyanatobiphenyl, 4,4'-dicyanatooctafluorobiphenyl, 2,4'- or 4,4'-dicyanatodiphenylmethane, bis(4-cyanato-3,5-dimethylphenyl)methane, 1,1-bis(4-cyanatophenyl)ethane, 1,1-bis(4-cyanatophenyl)propane, 2,2-bis(4-cyanatophenyl)propane, 2,2-bis(4-cyanato-3-methylphenyl)propane, 2,2-bis(2-cyanato-5-biphenylyl)propane, 2,2-bis(4-cyanatophenyl)hexafluoropropane, 2,2-bis(4-cyanato-3,5-dimethylphenyl)propane, 1,1-bis(4-cyanatophenyl)butane, 1,1-bis(4-cyanatophenyl)isobutane, 1,1-bis(4-cyanatophenyl)pentane, 1,1-bis(4-cyanatophenyl)-3-methylbutane, 1,1-bis(4-cyanatophenyl)-2-methylbutane, 1,1-bis(4-cyanatophenyl)-2,2-dimethylpropane, 2,2-bis(4-cyanatophenyl)butane, 2,2-bis(4-cyanatophenyl)pentane, 2,2-bis(4-cyanatophenyl)hexane, 2,2-bis(4-cyanatophenyl)-3-methylbutane, 2,2-bis(4-cyanatophenyl)-4-methylpentane, 2,2-bis(4-cyanatophenyl)-3,3-dimethylbutane, 3,3-bis(4-cyanatophenyl)hexane, 3,3-bis(4-cyanatophenyl)heptane, 3,3-bis(4-cyanatophenyl)octane, 3,3-bis(4-cyanatophenyl)-2-methylpentane, 3,3-bis(4-cyanatophenyl)-2-methylhexane, 3,3-bis(4-cyanatophenyl)-2,2-dimethylpentane, 4,4-bis(4-cyanatophenyl)-3-methylheptane, 3,3-bis(4-cyanatophenyl)-2-methylheptane, 3,3-bis(4-cyanatophenyl)-2,2-dimethylhexane, 3,3-bis(4-cyanatophenyl)-2,4-dimethylhexane, 3,3-bis(4-cyanatophenyl)-2,2,4-trimethylpentane, 2,2-bis(4-cyanatophenyl)-1,1,1,3,3,3-hexafluoropropane, bis(4-cyanatophenyl)phenylmethane, 1,1-bis(4-cyanatophenyl)-1-phenylethane, bis(4-cyanatophenyl)biphenylmethane, 1,1-bis(4-cyanatophenyl)cyclopentane, 1,1-bis(4-cyanatophenyl)cyclohexane, 2,2-bis(4-cyanato-3-isopropylphenyl)propane, 1,1-bis(3-cyclohexyl-4-cyanatophenyl)cyclohexane, bis(4-cyanatophenyl)diphenylmethane, bis(4-cyanatophenyl)-2,2-dichloroethylene, 1,3-bis[2-(4-cyanatophenyl)-2-propyl]benzene, 1,4-bis[2-(4-cyanatophenyl)-2-propyl]benzene, 1,1-bis(4-cyanatophenyl)-3,3,5-trimethylcyclohexane, 4-[bis(4-cyanatophenyl)methyl]biphenyl, 4,4-dicyanatobenzophenone, 1,3-bis(4-cyanatophenyl)-2-propen-1-one, bis(4-cyanatophenyl) ether, bis(4-cyanatophenyl) sulfide, bis(4-cyanatophenyl) sulfone, 4-cyanatobenzoic acid-4-cyanatophenyl ester (4-cyanatophenyl-4-cyanatobenzoate), bis-(4-cyanatophenyl) carbonate, 1,3-bis(4-cyanatophenyl)adamantane, 1,3-bis(4-cyanatophenyl)-5,7-dimethyladamantane, 3,3-bis(4-cyanatophenyl)isobenzofuran-1(3H)-one (a cyanate of phenolphthalein), 3,3-bis(4-cyanato-3-methylphenyl)isobenzofuran-1(3H)-one (a cyanate of o-cresolphthalein), 9,9'-bis(4-cyanatophenyl)fluorene, 9,9-bis(4-cyanato-3-methylphenyl)fluorene, 9,9-bis(2-cyanato-5-biphenylyl)fluorene, tris(4-cyanatophenyl)methane, 1,1,1-tris(4-cyanatophenyl)ethane, 1,1,3-tris(4-cyanatophenyl)propane, α,α,α'-tris(4-cyanatophenyl)-1-ethyl-4-isopropylbenzene, 1,1,2,2-tetrakis(4-cyanatophenyl)ethane, tetrakis(4-cyanatophenyl)methane, 2,4,6-tris(N-methyl-4-cyanatoanilino)-1,3,5-triazine, 2,4-bis(N-methyl-4-cyanatoanilino)-6-(N-methylanilino)-1,3,5-triazine, bis(N-4-cyanato-2-methylphenyl)-4,4'-oxydiphthalimide, bis(N-3-cyanato-4-methylphenyl)-4,4'-oxydiphthalimide, bis(N-4-cyanatophenyl)-4,4'-oxydiphthalimide, bis(N-4-cyanato-2-methylphenyl)-4,4'-(hexafluoroisopropylidene)diphthalimide, tris(3,5-dimethyl-4-cyanatobenzyl) isocyanurate, 2-phenyl-3,3-bis(4-cyanatophenyl)phthalimidine, 2-(4-methylphenyl)-3,3-bis(4-cyanatophenyl)phthalimidine, 2-phenyl-3,3-bis(4-cyanato-3-methylphenyl)phthalimidine, 1-methyl-3,3-bis(4-cyanatophenyl)indolin-2-one, 2-phenyl-3,3-bis(4-cyanatophenyl)indolin-2-one, and products obtained by cyanation of phenolic resins such as phenol novolac resins and cresol novolac resins (those obtained by reacting a phenol, an alkyl-substituted phenol, or a halogen-substituted phenol and a formaldehyde compound such as formalin or paraformaldehyde in an acidic solution by a known method), trisphenol novolac resins (those obtained by reacting hydroxybenzaldehyde and a phenol in the presence of an acidic catalyst), fluorene novolac resins (those obtained by reacting a fluorenone compound and a 9,9-bis(hydroxyaryl)fluorene in the presence of an acidic catalyst), phenol aralkyl resins, cresol aralkyl resins, naphthol aralkyl resins, and biphenyl aralkyl resins (those obtained by reacting a bishalogenomethyl compound as represented by Ar₂-(CH₂Y)₂ and a phenol compound with an acidic catalyst or without a catalyst by a known method, and those obtained by reacting a bis(alkoxymethyl) compound as represented by Ar₂-(CH₂OR)₂ or a bis(hydroxymethyl) compound as represented by Ar₂-(CH₂OH)₂ and a phenol compound in the presence of an acidic catalyst by a known method, or those obtained by polycondensing an aromatic aldehyde compound, an aralkyl compound, and a phenol compound by a known method), phenol-modified xylene formaldehyde resins (those obtained by reacting a xylene formaldehyde resin and a phenol compound in the presence of an acidic catalyst by a known method), modified naphthalene formaldehyde resins (those obtained by reacting a naphthalene formaldehyde resin and a hydroxy-substituted aromatic compound in the presence of an acidic catalyst by a known method), phenol-modified dicyclopentadiene resins, and phenolic resins having a polynaphthylene ether structure (those obtained by subjecting a polyvalent hydroxynaphthalene compound having two or more phenolic hydroxy groups in one molecule to dehydration condensation in the presence of a basic catalyst by a known method) by methods similar to the above. One of these other cyanate compounds (A) can be used alone, or two or more of these other cyanate compounds (A) can be mixed and used, provided that a naphthol-aralkyl cyanate compound is used as the cyanate compound (A).

The cyanate compound (A) is a naphthol aralkyl-based cyanate compound.

The naphthol aralkyl-based cyanate compound is not particularly limited as long as it has a structure in which a naphthalene ring having a cyanato group and a benzene ring are bonded to each other via an alkylene group. Examples of the naphthol aralkyl-based cyanate compounds include those in which in the above general formula (2), Ar₁ represents a naphthylene group, X is represented by the above general formula (3), and Ar₂ represents a phenylene group. Specifically, a cyanate compound represented by the following general formula (6) is preferred. In the cyanate compound represented by the following general formula (6), two methylene groups bonded to a benzene ring can be bonded to the ortho position, the meta position, or the para position. Among these, the two methylene groups bonded to the benzene ring are preferably bonded to the meta position or para position of the benzene ring. Cured products obtained from such naphthol aralkyl-based cyanate compounds tend to have a low thermal expansion coefficient and better combustibility, better low water absorbency, and better moisture absorption heat resistance. 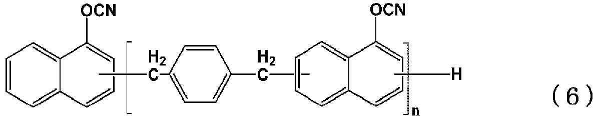 wherein n represents an integer of 1 to 50 and preferably represents an integer of 1 to 10.

A cured product of a resin composition using the above-described cyanate compound (A) tends to have characteristics better in high glass transition temperature, low thermal expansion properties, plating adhesiveness, and the like.

The content of the cyanate compound (A) in the resin composition in this embodiment is 1 to 90% by mass, more preferably 10 to 80% by mass, further preferably 20 to 70% by mass, and still further preferably 30 to 60% by mass based on the total amount (100% by mass) of resin solids in the resin composition. The resin composition in which the content of the cyanate compound (A) is in such a range tends to have better glass transition temperature when formed into a cured product.

In this embodiment, "the total amount of resin solids in the resin composition" refers to the total amount of resin components in the resin composition excluding a solvent and a filler (C) described later, unless otherwise noted. In addition, the resin components include at least the cyanate compound (A) and the epoxy resin (B) in the resin composition and also include other resin components.

The epoxy resin (B) in this embodiment (hereinafter also referred to as an "epoxy resin", a "component (B)", or "(B)") is represented by general formula (1): 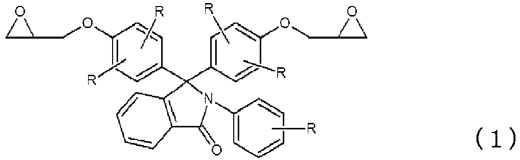 wherein a plurality of R each independently represent any of a hydrogen atom, an alkyl group having 1 to 6 carbon atoms, and an alkoxy group having 1 to 6 carbon atoms.

The alkyl group having 1 to 6 carbon atoms is not particularly limited. Examples thereof include alkyl groups having a linear, branched, or cyclic structure such as a methyl group, an ethyl group, a propyl group, a butyl group, a pentyl group, and a hexyl group. Among these, for the alkyl group having 1 to 6 carbon atoms, a methyl group and an ethyl group are preferred, and a methyl group is more preferred.

In addition, the alkoxy group having 1 to 6 carbon atoms is not particularly limited. Examples thereof include alkoxy groups having a linear, branched, or cyclic structure such as a methoxy group, an ethoxy group, a propoxy group, and a butoxy group. Among these, for the alkoxy group having 1 to 6 carbon atoms, a methoxy group, an ethoxy group, and a propoxy group are preferred, and a methoxy group is more preferred.

Among these illustrations, R more preferably represents a hydrogen atom from the viewpoint of heat resistance.

For the epoxy resin (B) represented by general formula (1), commercial epoxy resins may be used, and, for example, the trade name "WHR-991S" manufactured by Nippon Kayaku Co., Ltd. in which R represents a hydrogen atom is preferably used.

The content of the epoxy resin (B) represented by general formula (1) in the resin composition in this embodiment can be appropriately set according to the desired characteristics and is not particularly limited. However, the resin composition preferably contains 1 to 90% by mass, more preferably 10 to 80% by mass, further preferably 20 to 70% by mass, and still further preferably 30 to 60% by mass based on the epoxy resin (B) based on the total amount (100% by mass) of the resin solids in the resin composition. When the content of the epoxy resin (B) is in the range of 1 to 90% by mass, a resin composition that has better glass transition temperature when formed into a cured product tends to be obtained.

The resin composition in this embodiment preferably further contains the filler (C) (hereinafter also referred to as a "component (C)" or "(C)"). As the filler (C), known fillers can be appropriately used without being particularly limited, and the type of the filler (C) is also not particularly limited. Those generally used in the industry can be preferably used. Specific examples of the filler (C) include inorganic fillers such as silicas such as natural silica, fused silica, synthetic silica, amorphous silica, AEROSIL, and hollow silica; white carbon, titanium white, zinc oxide, magnesium oxide, zirconium oxide, boron nitride, aggregated boron nitride, silicon nitride, aluminum nitride, barium sulfate, aluminum hydroxide, heat-treated products of aluminum hydroxide (products obtained by heat-treating aluminum hydroxide to decrease some of the water of crystallization); metal hydrates such as boehmite and magnesium hydroxide; molybdenum compounds such as molybdenum oxide and zinc molybdate; zinc borate, zinc stannate, alumina, clay, kaolin, talc, calcined clay, calcined kaolin, calcined talc, mica, E-glass, A-glass, NE-glass, C-glass, L-glass, D-glass, S-glass, M-glass G20, glass short fibers (including fine powders of glass such as E glass, T glass, D glass, S glass, and Q glass), hollow glass, and spherical glass; and organic fillers such as rubber powders such as styrene-based rubber powders, butadiene-based rubber powders, and acrylic rubber powders; core-shell-based rubber powders, silicone resin powders, silicone rubber powders, and silicone composite powders. One of these fillers (C) can be used alone, or two or more of these fillers (C) can be used in combination.

By containing these fillers (C), the characteristics, such as thermal expansion characteristics, dimensional stability, and flame retardancy, of the resin composition tend to improve.

The content of the filler (C) in the resin composition in this embodiment can be appropriately set according to the desired characteristics and is not particularly limited. However, the resin composition preferably contains 50 to 1600 parts by mass of the filler (C) based on the total amount (100 parts by mass) of the resin solids in the resin composition. By setting the content of the filler (C) at 50 to 1600 parts by mass, the moldability of the resin composition tends to be good.

Here, when the filler (C) is used, a silane coupling agent and a wetting and dispersing agent are preferably used in combination. The silane coupling agent is not particularly limited. Those generally used for surface treatment of inorganic matter can be preferably used, and the type of the silane coupling agent is also not particularly limited. Specific examples of the silane coupling agent include aminosilane-based silane coupling agents such as γ-aminopropyltriethoxysilane and N-β-(aminoethyl)-γ-aminopropyltrimethoxysilane; epoxysilane-based silane coupling agents such as γ-glycidoxypropyltrimethoxysilane and β-(3,4-epoxycyclohexyl)ethyltrimethoxysilane; vinylsilane-based silane coupling agents such as γ-methacryloxypropyltrimethoxysilane and vinyl-tri(β-methoxyethoxy)silane; cationic silane-based silane coupling agents such as N-β-(N-vinylbenzylaminoethyl)-γ-aminopropyltrimethoxysilane hydrochloride; and phenylsilane-based silane coupling agents. One silane coupling agent can be used alone, or two or more silane coupling agents can be used in combination. In addition, the wetting and dispersing agent is not particularly limited. Those generally used for paints can be preferably used, and the type of the wetting and dispersing agent is also not particularly limited. For the wetting and dispersing agent, preferably copolymer-based wetting and dispersing agents are used. Specific examples of the copolymer-based wetting and dispersing agents are not particularly limited and include Disperbyk-110, 111, 161, and 180, BYK-W996, BYK-W9010, BYK-W903, and BYK-W940 manufactured by BYK Japan KK. One wetting and dispersing agent can be used alone, or two or more wetting and dispersing agents can be used in combination.

Further, the resin composition in this embodiment can further contain one or two or more selected from the group consisting of an epoxy resin other than the one represented by the above formula (1) (hereinafter referred to as "another epoxy resin"), a maleimide compound, a phenolic resin, an oxetane resin, a benzoxazine compound, and a compound having a polymerizable unsaturated group in a range in which the operation and effect according to the present invention are not impaired. By using the component (A) and the component (B) and these in combination, the desired characteristics, such as flame retardancy and low dielectric properties, of a cured product obtained by curing the resin composition tend to be able to be improved.

The another epoxy resin is not particularly limited as long as it is an epoxy resin that is not represented by general formula (1) and has two or more epoxy groups in one molecule. For example, known epoxy resins can be appropriately used, and the type of the another epoxy resin is also not particularly limited. Specific examples of the another epoxy resin include bisphenol A-based epoxy resins, bisphenol E-based epoxy resins, bisphenol F-based epoxy resins, bisphenol S-based epoxy resins, phenol novolac-based epoxy resins, bisphenol A novolac-based epoxy resins, glycidyl ester-based epoxy resins, aralkyl novolac-based epoxy resins, biphenyl aralkyl-based epoxy resins, naphthylene ether-based epoxy resins, cresol novolac-based epoxy resins, polyfunctional phenol-based epoxy resins, naphthalene-based epoxy resins, anthracene-based epoxy resins, naphthalene skeleton-modified novolac-based epoxy resins, phenol aralkyl-based epoxy resins, naphthol aralkyl-based epoxy resins, dicyclopentadiene-based epoxy resins, biphenyl-based epoxy resins, alicyclic epoxy resins, polyol-based epoxy resins, phosphorus-containing epoxy resins, glycidyl amines, glycidyl esters, compounds obtained by epoxidizing double bonds of butadiene and the like, and compounds obtained by reaction of hydroxyl group-containing silicone resins and epichlorohydrin, not represented by general formula (1). Among these other epoxy resins, biphenyl aralkyl-based epoxy resins, naphthylene ether-based epoxy resins, polyfunctional phenol-based epoxy resins, and naphthalene-based epoxy resins are preferred in terms of flame retardancy and heat resistance. One of these other epoxy resins can be used alone, or two or more of these other epoxy resins can be used in combination.

The maleimide compound is not particularly limited as long as it is a compound having one or more maleimide groups in one molecule. Those generally known can be used. Specific examples of the maleimide compound include 4,4-diphenylmethanebismaleimide, phenylmethanemaleimide, m-phenylenebismaleimide, 2,2-bis(4-(4-maleimidophenoxy)-phenyl)propane, 3,3-dimethyl-5,5-diethyl-4,4-diphenylmethanebismaleimide, 4-methyl-1,3-phenylenebismaleimide, 1,6-bismaleimido-(2,2,4-trimethyl)hexane, 4,4-diphenyl ether bismaleimide, 4,4-diphenyl sulfone bismaleimide, 1,3-bis(3-maleimidophenoxy)benzene, 1,3-bis(4-maleimidophenoxy)benzene, polyphenylmethanemaleimide, novolac-based maleimide, biphenyl aralkyl-based maleimide, and prepolymers of these maleimide compounds and prepolymers of maleimide compounds and amine compounds. One of these maleimide compounds can be used alone, or two or more of these maleimide compounds can be mixed and used. Among these, novolac-based maleimide compounds and biphenyl aralkyl-based maleimide compounds are preferred.

The phenolic resin is not particularly limited as long as it is a phenolic resin having two or more hydroxyl groups in one molecule. Those generally known can be used. Specific examples of the phenolic resin include bisphenol A-based phenolic resins, bisphenol E-based phenolic resins, bisphenol F-based phenolic resins, bisphenol S-based phenolic resins, phenol novolac resins, bisphenol A novolac-based phenolic resins, glycidyl ester-based phenolic resins, aralkyl novolac-based phenolic resins, biphenyl aralkyl-based phenolic resins, cresol novolac-based phenolic resins, polyfunctional phenolic resins, naphthol resins, naphthol novolac resins, polyfunctional naphthol resins, anthracene-based phenolic resins, naphthalene skeleton-modified novolac-based phenolic resins, phenol aralkyl-based phenolic resins, naphthol aralkyl-based phenolic resins, dicyclopentadiene-based phenolic resins, biphenyl-based phenolic resins, alicyclic phenolic resins, polyol-based phenolic resins, phosphorus-containing phenolic resins, and hydroxyl group-containing silicone resins. Among these phenolic resins, biphenyl aralkyl-based phenolic resins, naphthol aralkyl-based phenolic resins, phosphorus-containing phenolic resins, and hydroxyl group-containing silicone resins are preferred in terms of flame retardancy. Ghese phenolic resins can be used alone, or two or more of these phenolic resins can be used in combination.

The oxetane resin is not particularly limited, and those generally known can be used. Specific examples of the oxetane resin include oxetane, alkyloxetanes such as 2-methyloxetane, 2,2-dimethyloxetane, 3-methyloxetane, and 3,3-dimethyloxetane, 3-methyl-3-methoxymethyloxetane, 3,3-di(trifluoromethyl)perfluorooxetane, 2-chloromethyloxetane, 3,3-bis(chloromethyl)oxetane, biphenyl-based oxetane, OXT-101 (trade name manufactured by Toagosei Co., Ltd.), and OXT-121 (trade name manufactured by Toagosei Co., Ltd.). One of these oxetane resins can be used alone, or two or more of these oxetane resins can be mixed and used.

The benzoxazine compound is not particularly limited as long as it is a compound having two or more dihydrobenzoxazine rings in one molecule. Those generally known can be used. Specific examples of the benzoxazine compound include bisphenol A-based benzoxazine BA-BXZ (trade name manufactured by Konishi Chemical Ind. Co., Ltd.) bisphenol F-based benzoxazine BF-BXZ (trade name manufactured by Konishi Chemical Ind. Co., Ltd.), and bisphenol S-based benzoxazine BS-BXZ (trade name manufactured by Konishi Chemical Ind. Co., Ltd.). One of these benzoxazine compounds can be used alone, or two or more of these benzoxazine compounds can be mixed and used.

The compound having a polymerizable unsaturated group is not particularly limited, and those generally known can be used. Specific examples of the compound having a polymerizable unsaturated group include vinyl compounds such as ethylene, propylene, styrene, divinylbenzene, and divinylbiphenyl, (meth)acrylates of monohydric or polyhydric alcohols such as methyl (meth)acrylate, 2-hydroxyethyl (meth)acrylate, 2-hydroxypropyl (meth)acrylate, polypropylene glycol di(meth)acrylate, trimethylolpropane di(meth)acrylate, trimethylolpropane tri(meth)acrylate, pentaerythritol tetra(meth)acrylate, and dipentaerythritol hexa(meth)acrylate, epoxy (meth)acrylates such as bisphenol A-based epoxy (meth)acrylate and bisphenol F-based epoxy (meth)acrylate, benzocyclobutene resins, and (bis)maleimide resins. One of these compounds having an unsaturated group can be used alone, or two or more of these compounds having an unsaturated group can be mixed and used.

In addition, the resin composition in this embodiment may further contain a curing accelerator for appropriately adjusting the curing rate, as needed, though not particularly limited. This curing accelerator is not particularly limited. Those generally used as curing accelerators for cyanate compounds, epoxy resins, and the like can be preferably used, and the type of the curing accelerator is also not particularly limited. Specific examples of the curing accelerator include organometallic salts such as zinc octylate, zinc naphthenate, cobalt naphthenate, copper naphthenate, acetylacetone iron, nickel octylate, and manganese octylate; phenol compounds such as phenol, xylenol, cresol, resorcin, catechol, octyl phenol, and nonyl phenol; alcohols such as 1-butanol and 2-ethylhexanol; imidazoles such as 2-methylimidazole, 2-ethyl-4-methylimidazole, 2-phenylimidazole, 1-cyanoethyl-2-phenylimidazole, 1-cyanoethyl-2-ethyl-4-methylimidazole, 2-phenyl-4,5-dihydroxymethylimidazole, and 2-phenyl-4-methyl-5-hydroxymethylimidazole; derivatives such as adducts of carboxylic acids of these imidazoles and acid anhydrides thereof; amines such as dicyandiamide, benzyldimethylamine, and 4-methyl-N,N-dimethylbenzylamine; phosphorus compounds such as phosphine-based compounds, phosphine oxide-based compounds, phosphonium salt-based compounds, and diphosphine-based compounds; epoxy-imidazole adduct-based compounds, peroxides such as benzoyl peroxide, p-chlorobenzoyl peroxide, di-t-butyl peroxide, diisopropyl peroxycarbonate, and di-2-ethylhexyl peroxycarbonate; and azo compounds such as azobisisobutyronitrile. One curing accelerator can be used alone, or two or more curing accelerators can be used in combination.

The content of the curing accelerator can be appropriately adjusted considering the degrees of cure of the resins, the viscosity of the resin composition, and the like and is not particularly limited. However, preferably, the resin composition contains 0.005 to 10 parts by mass of the curing accelerator based on the total amount (100 parts by mass) of the resin solids in the resin composition.

Further, the resin composition in this embodiment can further contain various polymer compounds such as a thermosetting resin, a thermoplastic resin, and an oligomer thereof, and an elastomer, a flame-retardant compound, various additives, and the like other than those described above in a range in which the operation and effect according to the present invention are not impaired. These are not particularly limited as long as they are those generally used. The flame-retardant compound is not particularly limited. Examples thereof include bromine compounds such as 4,4'-dibromobiphenyl, phosphates, melamine phosphate, phosphorus-containing epoxy resins, nitrogen compounds such as melamine and benzoguanamine; oxazine ring-containing compounds, and silicone-based compounds. In addition, the various additives are not particularly limited. Examples thereof include ultraviolet absorbing agents, antioxidants, photopolymerization initiators, fluorescent brightening agents, photosensitizers, dyes, pigments, thickening agents, flow-adjusting agents, lubricants, defoaming agents, dispersing agents, leveling agents, brightening agents, and polymerization inhibitors. One of these can be used alone or two or more of these can be used in combination as desired.

The resin composition in this embodiment can further contain an organic solvent as needed. In this case, the resin composition in this embodiment can be used as a form (solution or varnish) in which at least some, preferably all, of the above-described various resin components are dissolved in or compatible with the organic solvent. The organic solvent is not particularly limited as long as it can dissolve or be compatible with at least some, preferably all, of the above-described various resin components. Known ones can be appropriately used, and the type of the organic solvent is also not particularly limited. Specific examples of the organic solvent include polar solvents such as ketones such as acetone, methyl ethyl ketone, and methyl isobutyl ketone; cellosolve-based solvents such as propylene glycol monomethyl ether and propylene glycol monomethyl ether acetate; ester-based solvents such as ethyl lactate, methyl acetate, ethyl acetate, butyl acetate, isoamyl acetate, methyl methoxypropionate, and methyl hydroxyisobutyrate; and amides such as dimethylacetamide and dimethylformamide; and nonpolar solvents such as aromatic hydrocarbons such as toluene and xylene. One of these can be used alone, or two or more of these can be used in combination.

The resin composition in this embodiment can be prepared according to an ordinary method. The method for preparing the resin composition in this embodiment is not particularly limited as long as it is a method in which a resin composition uniformly containing the cyanate compound (A) and the epoxy resin (B) represented by general formula (1) is obtained. The method is preferably a method in which a resin composition also uniformly containing the above-described other optional components is obtained. As a specific example of the preparation method, for example, the resin composition in this embodiment can be easily prepared by sequentially blending the cyanate compound (A) and the epoxy resin (B) represented by general formula (1) with a solvent and sufficiently stirring the blend.

During preparation of the resin composition, known treatment (for example, stirring, mixing, and kneading treatment) for uniformly dissolving or dispersing the components can be performed. For example, in uniform dispersion of the filler (C), by performing stirring and dispersion treatment using a stirring vessel provided with a stirrer having suitable stirring ability, the dispersibility in the resin composition tends to be increased. The above stirring, mixing, and kneading treatment can be appropriately performed, for example, using known apparatuses such as apparatuses intended for mixing such as ball mills and bead mills, and revolution-rotation mixing apparatuses.

The resin composition in this embodiment can be used as a material for an insulating layer of a printed wiring board and a semiconductor package material though not particularly limited. For example, a prepreg can be provided by impregnating or coating a base material with a solution of the resin composition in this embodiment dissolved in a solvent and drying the solution.

In addition, a resin sheet can be provided by using a peelable plastic film as a support, coating the plastic film with a solution of the resin composition in this embodiment dissolved in a solvent, and drying the solution. The resin sheet can be used as a buildup film or a dry film solder resist. Here, the solvent can be dried by heating at a temperature of 20°C to 150°C for 1 to 90 minutes. In addition, the resin composition can also be used in an uncured state in which the solvent is only dried, or in a semi-cured (B-staged) state as needed.

### <Prepreg>

A prepreg in this embodiment will be described in detail below. The prepreg in this embodiment comprises a base material; and the resin composition in this embodiment described above with which the base material is impregnated or coated. The method for producing the prepreg is not particularly limited as long as it is a method of combining the resin composition in this embodiment and a base material to produce a prepreg. The prepreg is obtained by impregnating or coating a base material with the resin composition in this embodiment described above. More specifically, the prepreg in this embodiment can be produced by impregnating or coating a base material with the resin composition in this embodiment and then semi-curing the resin composition by a method involving drying at 120 to 220°C for about 2 to 15 minutes, or the like. At this time, the amount of the resin composition adhered to the base material, that is, the amount of the resin composition (including the filler (C)) based on the total amount (100% by mass) of the prepreg after the semi-curing, is preferably in the range of 20 to 99% by mass.

The base material in this embodiment is not particularly limited, and, for example, known base materials used for various printed wiring board materials can be used. Specific examples of the base material include woven fabrics of fibers of glass such as E glass, D glass, L glass, S glass, T glass, Q glass, UN glass, NE glass, and spherical glass; inorganic fibers of materials other than glass, such as quartz; organic fibers of polyimides, polyamides, polyesters, and the like; liquid crystal polyesters; and the like. The shape of the base material is not particularly limited. Examples thereof include woven fabrics, nonwoven fabrics, rovings, chopped strand mats, and surfacing mats. The shape of the base material may be any. One base material can be used alone, or two or more base materials can be used in combination. In addition, although not particularly limited, in laminate applications, the thickness of the base material is preferably in the range of 0.01 to 0.2 mm, and it is preferred from the viewpoint of dimensional stability that the base material is particularly a woven fabric subjected to ultra-opening treatment or clogging treatment. Further, glass woven fabrics surface-treated with silane coupling agents for epoxysilane treatment, aminosilane treatment, and the like are preferred from the viewpoint of moisture absorption heat resistance. In addition, liquid crystal polyester woven fabrics are preferred in terms of electrical characteristics.

### <Metal Foil-Clad Laminate>

A metal foil-clad laminate in this embodiment comprises one of the prepreg in this embodiment described above or two or more of the prepregs in this embodiment described above laminated; and metal foil laminate-molded on one surface or both surfaces of the prepreg. Specifically, the metal foil-clad laminate can be fabricated by using one of the above-described prepreg or stacking a plurality of the above-described prepregs, disposing foil of a metal such as copper or aluminum on one surface or both surfaces of the prepreg or the stack, and laminate-molding the metal foil and the prepreg or the stack. The metal foil in this embodiment is not particularly limited as long as it is a metal foil that can be used for a printed wiring board material. Copper foil such as rolled copper foil and electrolytic copper foil is preferred. In addition, the thickness of the metal foil is not particularly limited but is preferably 2 to 70 µm, more preferably 3 to 35 µm. As the molding conditions, usual methods for laminates and multilayer boards for printed wiring boards can be applied. For example, the metal foil-clad laminate in this embodiment can be produced by laminate-molding with a temperature of 180 to 350°C, a heating time of 100 to 300 minutes, and a surface pressure of 20 to 100 kg/cm² using a multistage press, a multistage vacuum press, a continuous molding machine, an autoclave molding machine, or the like. In addition, a multilayer board can also be provided by laminate-molding the above prepreg and a separately fabricated wiring board for an inner layer in combination. As the method for producing a multilayer board, for example, a multilayer board can be fabricated by disposing 35 µm copper foil on both surfaces of one of the above-described prepreg, laminating and forming the copper foil and the prepreg under the above conditions, then forming inner layer circuits, subjecting these circuits to blackening treatment to form an inner layer circuit board, then alternately disposing these inner layer circuit boards and the above prepregs one by one, further disposing copper foil on the outermost layers, and laminate-molding the copper foil, the inner layer circuit boards, and the prepregs under the above conditions preferably under vacuum.

The metal foil-clad laminate in this embodiment can be preferably used as a printed wiring board. The printed wiring board can be produced according to an ordinary method, and the method for producing the printed wiring board is not particularly limited. One example of a method for producing a printed wiring board will be shown below. First, a metal foil-clad laminate such as the above-described copper-clad laminate is provided. Next, the surfaces of the metal foil-clad laminate are subjected to etching treatment to form inner layer circuits to fabricate an inner layer board. The inner layer circuit surfaces of this inner layer board are subjected to surface treatment for increasing adhesive strength, as needed. Then, the required number of the above-described prepregs are stacked on the inner layer circuit surfaces, metal foil for outer layer circuits is further laminated on the outside of the stack, and heat and pressure are applied for integral molding. In this manner, a multilayer laminate in which insulating layers comprising a base material and a cured product of a thermosetting resin composition are formed between inner layer circuits and metal foil for outer layer circuits is produced. Then, this multilayer laminate is subjected to perforation for through holes and via holes, and then plating metal films that allow conduction between the inner layer circuits and the metal foil for outer layer circuits are formed on the wall surfaces of these holes. Further, the metal foil for outer layer circuits is subjected to etching treatment to form outer layer circuits. Thus, a printed wiring board is produced.

### <Printed Wiring Board>

A printed wiring board in this embodiment comprises an insulating layer comprising the resin composition in this embodiment described above; and a conductor layer formed on one surface or both surfaces of the insulating layer. The insulating layer has a configuration in which it comprises the resin composition in this embodiment described above. In other words, the prepreg in this embodiment described above (the base material and the resin composition in this embodiment with which the base material is impregnated or coated) and the resin composition layer of the metal foil-clad laminate in this embodiment described above (the layer comprising the resin composition in this embodiment) are composed of an insulating layer comprising the resin composition in this embodiment.

### <Resin Sheet>

A resin sheet in this embodiment comprises a sheet base material; and the resin composition in this embodiment described above applied and dried on one surface or both surfaces of the sheet base material. The resin sheet can be obtained by coating a sheet base material with a solution of the resin composition dissolved in a solvent (resin composition) (applying a solution of the resin composition dissolved in a solvent (resin composition)) to a sheet base material) and drying the solution. The sheet base material in this embodiment is not particularly limited. Examples thereof include organic film base materials such as polyethylene films, polypropylene films, polycarbonate films, polyethylene terephthalate films, ethylene-tetrafluoroethylene copolymer films, and release films obtained by coating surfaces of these films with release agents, and polyimide films, conductor foil such as copper foil and aluminum foil, and plate-shaped base materials such as glass plates, SUS plates, and FRP. The coating method is not particularly limited. Examples thereof include a method of coating a sheet base material with a solution of the resin composition in this embodiment dissolved in a solvent by a bar coater, a die coater, a doctor blade, a baker applicator, or the like. In addition, a single-layer sheet (resin sheet) can also be provided by drying the solution after coating, and peeling or etching the resin sheet from the laminated sheet. A single-layer sheet (resin sheet) can also be obtained without using a sheet base material by supplying a solution of the above resin composition in this embodiment dissolved in a solvent into a mold having a sheet-shaped cavity, and drying the solution, or the like for molding into a sheet shape.

In fabrication of the single-layer sheet or the laminated resin sheet in this embodiment, the drying conditions when the solvent is removed are not particularly limited but are preferably a temperature of 20°C to 200°C for 1 to 90 minutes because at low temperature, the solvent is likely to remain in the resin composition, and at high temperature, curing of the resin composition proceeds. In addition, the thickness of the single-layer sheet or the resin layer of the laminated resin sheet in this embodiment can be adjusted by the concentration and coating thickness of the solution of the resin composition in this embodiment and is not particularly limited but is preferably 0.1 to 500 µm because generally, when the coating thickness increases, the solvent is likely to remain during drying.

### Examples

This embodiment will be described in more detail below by showing Synthesis Examples, an Example, and Comparative Examples, but this embodiment is not limited by these in any way.

### (Synthesis Example 1) Synthesis of Cyanate Compound

300 g (1.28 mol in terms of OH groups) of a 1-naphthol aralkyl resin (manufactured by NIPPON STEEL & SUMIKIN CHEMICAL CO., LTD.) and 194.6 g (1.92 mol) (1.5 mol based on 1 mol of hydroxy groups) of triethylamine were dissolved in 1800 g of dichloromethane, and this solution was a solution 1.

While 125.9 g (2.05 mol) (1.6 mol based on 1 mol of hydroxy groups) of cyanogen chloride, 293.8 g of dichloromethane, 194.5 g (1.92 mol) (1.5 mol based on 1 mol of hydroxy groups) of 36% hydrochloric acid, and 1205.9 g of water were kept at a liquid temperature of -2 to -0.5°C under stirring, the solution 1 was poured over 30 minutes. After completion of pouring of the solution 1, the mixture was stirred at the same temperature for 30 minutes, and then a solution of 65 g (0.64 mol) (0.5 mol based on 1 mol of hydroxy groups) of triethylamine dissolved in 65 g of dichloromethane (solution 2) was poured over 10 minutes. After completion of pouring of the solution 2, the mixture was stirred at the same temperature for 30 minutes to complete the reaction.

Then, the reaction liquid was allowed to stand to separate the organic phase and the aqueous phase. The obtained organic phase was washed five times with 1300 g of water. The electrical conductivity of the wastewater from the fifth water washing was 5 µS/cm, and it was confirmed that removable ionic compounds were sufficiently removed by the washing with water.

The organic phase after the water washing was concentrated under reduced pressure and finally concentrated to dryness at 90°C for 1 hour to obtain 331 g of the target naphthol aralkyl-based cyanate compound (SNCN) (orange viscous material). The mass average molecular weight Mw of the obtained SNCN was 600. In addition, the IR spectrum of SNCN showed absorption at 2250 cm⁻¹ (cyanate groups) and showed no absorption of hydroxy groups.

### (Example 1)

50 parts by mass of the SNCN obtained by Synthesis Example 1, 50 parts by mass of an epoxy resin represented by the following formula (9) (WHR-991S, manufactured by Nippon Kayaku Co., Ltd.), 100 parts by mass of fused silica (SC2050MB, manufactured by Admatechs Company Limited), and 0.15 parts by mass of zinc octylate (manufactured by Nihon Kagaku Sangyo Co., Ltd.) were mixed to obtain a varnish. This varnish was diluted with methyl ethyl ketone, and an E-glass woven fabric having a thickness of 0.1 mm was impregnated and coated with the diluted varnish and heated and dried at 150°C for 5 minutes to obtain a prepreg having a resin content of 50% by mass.

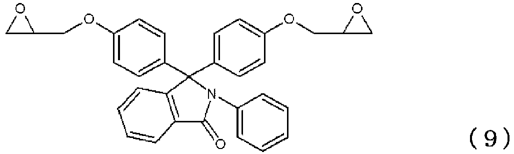

Eight of the obtained prepregs were stacked, and 12 µm thick electrolytic copper foil (3EC-M3-VLP, manufactured by MITSUI MINING & SMELTING CO., LTD.) was disposed on the top and the bottom. The stack was laminate-molded at a pressure of 30 kgf/cm² and a temperature of 220°C for 120 minutes to obtain a metal foil-clad laminate having an insulating layer thickness of 0.8 mm. Evaluation of glass transition temperature (Tg) was performed using the obtained metal foil-clad laminate. The result is shown in Table 1.

### (Comparative Example 1)

A metal foil-clad laminate having a thickness of 0.8 mm was obtained as in Example 1 except that 50 parts by mass of a biphenyl aralkyl-based epoxy resin (NC-3000-FH, manufactured by Nippon Kayaku Co., Ltd.) was used instead of using 50 parts by mass of the epoxy resin represented by formula (9), and zinc octylate was used with the amount changed from 0.15 parts by mass to 0.12 parts by mass, in Example 1. The evaluation result of the obtained metal foil-clad laminate is shown in Table 1.

### (Measurement Methods and Evaluation Methods)

Glass transition temperature: Each of the metal foil-clad laminates obtained in Example 1 and Comparative Example 1 was cut to a size of 40 mm × 20 mm, and the glass transition temperature was measured by a dynamic viscoelasticity measuring apparatus (manufactured by TA Instruments) in accordance with JIS C6481.

Plating peel strength: The electrolytic copper foil of the metal foil-clad laminate obtained in Example 1 was removed by etching, and the laminate was immersed in a swelling treatment liquid (400 ml/L of OPC-B103 Pre Etch, 13 g/L of sodium hydroxide) manufactured by Okuno Chemical Industries Co., Ltd. at 65°C for 5 minutes. Next, the laminate was immersed in a roughening treatment liquid (100 ml/L of OPC-1540MN, 100 ml/L of OPC-1200 Epo Etch) manufactured by Okuno Chemical Industries Co., Ltd. at 80°C for 8 minutes. Finally, the laminate was subjected to desmear treatment in a neutralization treatment liquid (200 ml/L of OPC-1300 Neutralizer) manufactured by Okuno Chemical Industries Co., Ltd. at 45°C for 5 minutes. Then, electroless copper plating of about 0.5 µm was provided by the process of electroless copper plating manufactured by Okuno Chemical Industries Co., Ltd. (names of chemical solutions used: OPC-370 Condiclean M, OPC-SAL M, OPC-80 Catalyst, OPC-555 Accelerator M, ATS Addcopper IW), and drying was performed at 130°C for 1 hour. Next, electrolytic copper plating was provided so that the thickness of plating copper was 18 µm, and drying was performed at 180°C for 1 hour. In this manner, a circuit wiring board sample in which a conductor layer (plating copper) having a thickness of 18 µm was formed on an insulating layer was fabricated. Using the circuit wiring board sample, the adhesive force of the plating copper was measured three times in accordance with JIS C6481, and the average value was obtained as plating peel strength.

**[Table 1]**

| | | Example 1 | Comparative Example 1 |
|---|---|---|---|
| Glass transition temperature | (°C) | 292 | 250 |
| Plating peel strength | [kg/cm] | 0.29 | - |

As is clear from Table 1, it was at least confirmed that by using the resin composition in the Example, a prepreg, a metal foil-clad laminate, and a printed wiring board that had excellent glass transition temperature were realized.

### Industrial Applicability

As described above, the resin composition according to the present invention can be widely and effectively used in various applications such as electrical and electronic materials, machine tool materials, and aviation materials, for example, as electrical insulating materials, semiconductor plastic packages, sealing materials, adhesives, lamination materials, resists, and buildup laminate materials, and, particularly, can be especially effectively used as printed wiring board materials adapted to higher integration and higher density for information terminal equipment, communication equipment, and the like in recent years. In addition, the prepreg, the metal foil-clad laminate, the resin sheet, and the printed wiring board according to the present invention have performance excellent in glass transition temperature, and therefore their industrial practicality is extremely high.

## Claims

1. A resin composition comprising a cyanate compound (A); and an epoxy resin (B) represented by general formula (1): 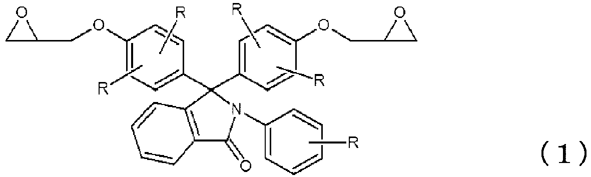 wherein a plurality of R each independently represent any of a hydrogen atom, an alkyl group having 1 to 6 carbon atoms, and an alkoxy group having 1 to 6 carbon atoms; wherein the cyanate compound (A) is comprised in 1 to 90% by mass and the epoxy resin (B) is comprised in 1 to 90% by mass based on a total amount (100% by mass) of resin solids in the resin composition; and
wherein the cyanate compound (A) is a naphthol aralkyl-based cyanate compound.

2. The resin composition according to claim 1, further comprising a filler (C).

3. The resin composition according to claim 1 or 2, further comprising one or two or more selected from the group consisting of an epoxy resin other than the epoxy resin (B) represented by the general formula (1), a maleimide compound, a phenolic resin, an oxetane resin, a benzoxazine compound, and a compound having a polymerizable unsaturated group.

4. The resin composition according to claim 2 or 3, comprising 50 to 1600 parts by mass of the filler (C) based on the total amount (100 parts by mass) of the resin solids in the resin composition.

5. A prepreg comprising a base material; and the resin composition according to any one of claims 1 to 4 with which the base material is impregnated or coated.

6. A metal foil-clad laminate comprising one of the prepreg according to claim 5 or two or more of the prepregs according to claim 5 laminated; and metal foil laminate-molded on one surface or both surfaces of the prepreg.

7. A resin sheet comprising a sheet base material; and the resin composition according to any one of claims 1 to 4 applied and dried on one surface or both surfaces of the sheet base material.

8. A printed wiring board comprising an insulating layer comprising the resin composition according to any one of claims 1 to 4; and a conductor layer formed on one surface or both surfaces of the insulating layer.

## Patentansprüche

1. Harzzusammensetzung, umfassend eine Cyanat-Verbindung (A); und ein Epoxidharz (B), dargestellt durch die allgemeine Formel (1): 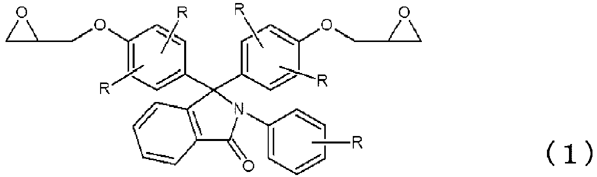
worin mehrere R jeweils unabhängig ein Wasserstoffatom, eine Alkylgruppe mit 1 bis 6 Kohlenstoffatomen oder eine Alkoxygruppe mit 1 bis 6 Kohlenstoffatomen darstellen;
wobei die Cyanat-Verbindung (A) zu 1 bis 90 Massenprozent enthalten ist und das Epoxidharz (B) zu 1 bis 90 Massenprozent enthalten ist, bezogen auf die Gesamtmenge (100 Massenprozent) der Harzfeststoffe in der Harzzusammensetzung; und
wobei die Cyanat-Verbindung (A) eine Cyanat-Verbindung auf Naphtholaralkyl-Basis ist.

2. Harzzusammensetzung gemäß Anspruch 1, ferner umfassend einen Füllstoff (C).

3. Die Harzzusammensetzung gemäß Anspruch 1 oder 2, ferner umfassend ein oder zwei oder mehr, ausgewählt aus einer Gruppe bestehend aus einem Epoxidharz, das verschieden ist von dem durch die allgemeine Formel (1) dargestellten Epoxidharz (B), einer Maleimidverbindung, einem Phenolharz, einem Oxetanharz, einer Benzoxazinverbindung und einer Verbindung mit einer polymerisierbaren ungesättigten Gruppe.

4. Harzzusammensetzung gemäß Anspruch 2 oder 3, umfassend 50 bis 1600 Massenteile des Füllstoffs (C), bezogen auf die Gesamtmenge (100 Massenteile) der Harzfeststoffe in der Harzzusammensetzung.

5. Prepreg, umfassend ein Basismaterial und die Harzzusammensetzung gemäß mindestens einem der Ansprüche 1 bis 4, mit der das Basismaterial imprägniert oder beschichtet ist.

6. Metallfolienkaschiertes Laminat, umfassend ein Prepreg gemäß Anspruch 5 oder zwei oder mehr der Prepregs gemäß Anspruch 5, die laminiert sind, und eine Metallfolie, die auf eine Oberfläche oder beide Oberflächen des Prepregs laminiert ist.

7. Harzplatte, umfassend ein Plattenbasismaterial und die Harzzusammensetzung gemäß mindestens einem der Ansprüche 1 bis 4, die auf einer Oberfläche oder beiden Oberflächen des Plattenbasismaterials aufgetragen und getrocknet ist.

8. Gedruckte Leiterplatte mit einer Isolierschicht, umfassend die Harzzusammensetzung gemäß mindestens einem der Ansprüche 1 bis 4 und eine Leiterschicht, die auf einer Oberfläche oder beiden Oberflächen der Isolierschicht ausgebildet ist.

## Revendications

1. Composition de résine comprenant un composé cyanate (A) ; et une résine époxy (B) représentée par la formule générale (1) : 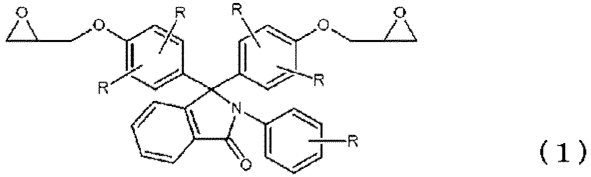
dans laquelle une pluralité de R représentent chacun indépendamment l'un des éléments parmi un atome d'hydrogène, un groupe alkyle présentant de 1 à 6 atomes de carbone, et un groupe alcoxy présentant de 1 à 6 atomes de carbone ;
dans laquelle le composé cyanate (A) est compris dans la plage allant de 1 à 90 % en masse et la résine époxy (B) est comprise dans la plage allant de 1 à 90 % en masse sur la base d'une quantité totale (100 % en masse) de solides résineux dans la composition de résine ; et
dans laquelle le composé cyanate (A) est un composé cyanate à base de naphtol-aralkyle.

2. Composition de résine selon la revendication 1, comprenant en outre une charge (C).

3. Composition de résine selon la revendication 1 ou 2, comprenant en outre un ou deux ou plusieurs éléments choisis parmi le groupe consistant en une résine époxy différente de la résine époxy (B) représentée par la formule générale (1), un composé maléimide, une résine phénolique, une résine oxétane, un composé benzoxazine, et un composé présentant un groupe insaturé polymérisable.

4. Composition de résine selon la revendication 2 ou 3, comprenant de 50 à 1600 parties en masse de la charge (C) sur la base de la quantité totale (100 parties en masse) de solides résineux dans la composition de résine.

5. Préimprégné comprenant un matériau de base ; et la composition de résine selon l'une quelconque des revendications 1 à 4 avec laquelle le matériau de base est imprégné ou enrobé.

6. Stratifié plaqué d'une feuille métallique comprenant l'un parmi le préimprégné selon la revendication 5 ou deux ou plusieurs des préimprégnés selon la revendication 5 stratifiés ; et stratifié de feuille métallique moulé sur une surface ou les deux surfaces du préimprégné.

7. Feuille de résine comprenant un matériau de base en feuille ; et composition de résine selon l'une quelconque des revendications 1 à 4 appliquée et séchée sur une surface ou les deux surfaces du matériau de base en feuille.

8. Carte de circuit imprimé comprenant une couche isolante comprenant la composition de résine selon l'une quelconque des revendications 1 à 4; et une couche conductrice formée sur une surface ou les deux surfaces de la couche isolante.
